# EUROPEAN PATENT APPLICATION

(11) **EP 0 926 731 A1**
(43) Date of publication of application: **30.06.1999**
(21) Application number: 97830685.0
(22) Date of filing: 18.12.1997
(51) Int. Cl.: H01L 23/31, H01L 21/316

(54) **Process for the final passivation of intergrated circuits**

(71) Applicant: STMicroelectronics S.r.l., 20041 Agrate Brianza (Milano) (IT)
(72) Inventor: Locati, Vanda, 24126 Bergamo (IT); Clemente, Gino, 20044 Bernareggio (Milano) (IT)
(74) Representative: Mittler, Enrico

(57) **Abstract**

Process for passivating an integrated circuit, providing for the formation on a top surface of the integrated circuit of at least a first layer of undoped oxide (5), characterized in that said first layer of undoped oxide (5) is formed by means of a chemical vapor deposition process performed at a pressure suitable for causing said first undoped oxide layer to substantially completely fill hollow regions between projecting regions (2) of the top surface of the integrated circuit.

## Description

The present invention relates to a process for the final passivation of integrated circuits.

As known, integrated circuits are to be passivated in order to protect them from mechanical stresses and contamination. In particular, the passivation film shall have excellent properties of hermetic seal around the vertical walls of the strips formed in the uppermost metal level. Such feature is extremely difficult to achieve when the geometry of the integrated circuit becomes very small, and particularly if the exposed area of the vertical walls of the metal strips is significantly larger than the exposed area of the top of the strips.

A known passivation process is disclosed in EP-A-0655776. This process provides for forming over a top surface of an integrated circuit to be protected a layer of undoped silicon dioxide (Undoped Silicon Glass or USG) layer, then a layer of phosphorus-doped silicon dioxide (Phosphorus doped Silicon Glass or PSG) and then a layer of silicon oxidonitride (SixOyNz).

Normally the passivation layer is formed by deposition over the whole surface of the integrated circuit. Subsequently, the passivation layer is selectively removed from over the bonding pad areas (areas wherein conductive wires are to be soldered to enlarged metallized regions) by means of conventional photolithographic techniques (deposition of photoresist material, exposure to light, selective removal of the photoresist, etching of the uncovered areas of the passivation layer, complete removal of the remaining photoresist).

The above-mentioned passivation process providing for the formation of triple layer of undoped oxide, doped oxide and oxidonitride does not assure the filling of the gaps between the metal strips and is therefore subject to limitations, such as formation of cracks, popping of the photoresist, presence of residual photoresist within the gaps between the metal strips, etc.

In view of the state of the art described, it is an object of the present invention to provide a process for the final passivation of integrated circuits resolving the problems connected to the use of the known passivation processes in a context of continuous reduction of the geometries of the integrated circuits.

According to the present invention such an object is achieved by means of a process for the final passivation of an integrated circuit, providing for the formation on a top surface of the integrated circuit of at least a first layer of undoped oxide, characterized in that said first layer of undoped oxide is formed by means of a chemical vapor deposition process performed at a pressure suitable for causing said first undoped oxide layer to substantially completely fill hollow regions between projecting regions of the top surface of the integrated circuit.

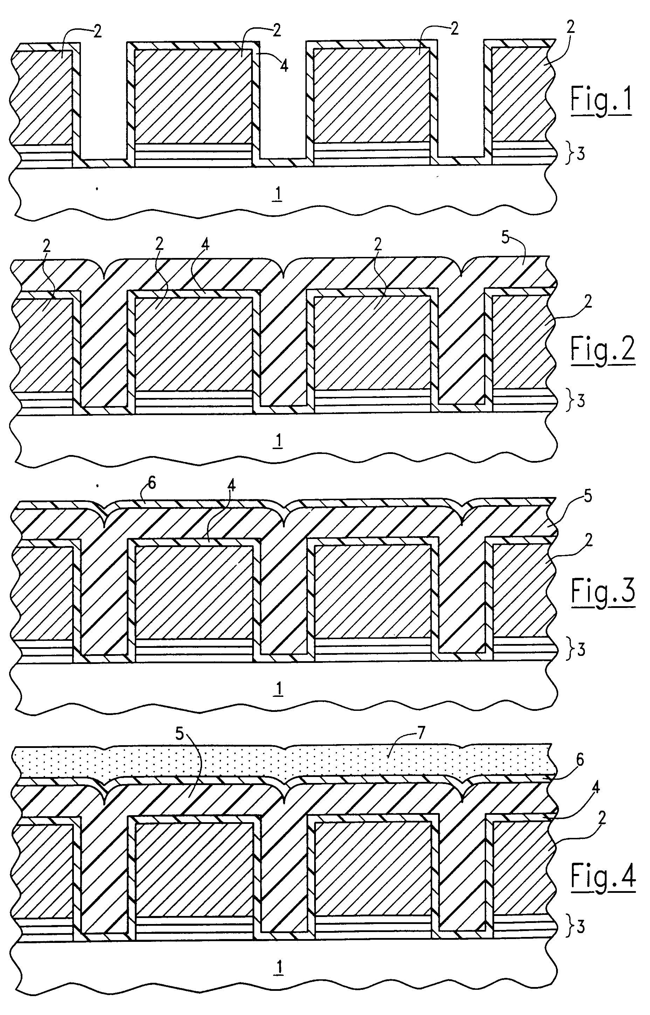

The features and advantages of the present invention will be made apparent from the following detailed description of one practical embodiment thereof, illustrated by way of non-limiting example in the annexed drawings, wherein
Figures 1 to 4 are cross-sectional views of a portion of an integrated circuit to be passivated, taken at intermediate steps of a process of final passivation according to an embodiment of the present invention.

Referring to the drawings, in Figure 1 a portion of an integrated circuit to be passivated is shown. The integrated circuit generically comprises a semiconductor material substrate 1 over which a pattern of, e.g., metal strips 2 is formed, the metal strips 2 being for example formed over a stack 3 of other layers of different materials. This is not essential to the present invention; the only thing to be noted is that generally the surface of the integrated circuit to be passivated is rough, with projecting regions and hollow regions.

In its preferred embodiment, the process of final passivation of the present invention provides for the formation over the top surface of the integrated circuit to be passivated of a first layer 4 of undoped silicon dioxide, which acts as a barrier layer. As shown in Figure 1, this layer 4 follows the profile of the integrated circuit surface, but does not fill the hollow regions between the metal strips 2. The formation of this layer 4 can be achieved by means of conventional Chemical Vapor Deposition (CVD).

Subsequently (Figure 2), a second layer of undoped silicon dioxide 5 is formed. This layer is also formed by means of CVD, as layer 4. However, while layer 4 is formed by means of a substantially conventional CVD process, the deposition for the formation of layer 5 is performed at a pressure in a range suitable for the layer 5 to have a good filling factor. It has in fact been verified that, as far as the capability of filling hollow regions is concerned, the pressure is the most important process parameter in a process of formation of an oxide layer by means of CVD. Suitable pressure values range of 350 to 600 Torr, which make the deposition process a Sub-Atmospheric pressure CVD (SACVD).

Preferably, the step of deposition of the filling oxide layer 5 is preceded by a step of deposition of a so-called "glue layer", performed in the same reaction chamber with the same chemical reactants as the step of deposition of the filling oxide layer 5, but at a much lower pressure of, e.g., 40 to 60 Torr.

As schematically shown in Figure 2, layer 5 completely fills the gaps between the metal strips 2.

Then, a third layer of undoped silicon dioxide 6 is formed, again by means of conventional CVD, over the filling layer 5 to encapsulate the underlying layers (Figure 3). The process conditions for the deposition of layer 6 can be identical to those used for depositing the barrier layer 4.

The thickness of the three undoped oxide layers 4, 5 and 6, and in particular the thickness of the filling oxide layer 5, depends on the desired particular the thickness of the filling oxide layer 5, depends on the desired filling factor as well as on the smallest gaps to be filled. However, it is also to be taken into consideration that an important limiting factor for the layer's thickness is related to the stresses of the underlying and overlying layers.

The passivation process can be completed with the formation of layers (schematically indicated with 7 in Figure 4) of material conventionally employed in standard final passivation processes. For example, over layer 6 a layer of doped silicon dioxide can be formed, as well as a layer of silicon oxidonitride. In the case of integrated circuits including UV erasable memory cells, oxidonitride shall not be used, because it blocks UV rays.

The present description has been directed to a preferred embodiment of the invention, providing for the deposition of three layers 4, 5 and 6 of undoped silicon dioxide. However, it should be noted that the present invention could as well provide for the formation of only one layer, namely the filling layer 5, which can be considered the essential feature of the invention. It is the filling layer 5 that fills the gaps between the metal strips 2, preventing that other materials, such as e.g. the photoresist used for the selective etching of the passivation layer over the bonding pads, penetrates in the hollow regions.

However, the three layers of undoped oxide 4, 5 and 6 can be advantageously formed in sequence, varying the process condition (in particular, the pressure) inside the reaction chamber used for the chemical vapor deposition.

The passivation process according to the present invention is advantageous in that it is compatible with the already existing passivation processes, and it can easily implemented. Additionally, the process of the invention provides a good degree of filling even in presence of structures having large aspect ratios, and at the same time provides a good degree of planarization.

## Claims

1. Process for passivating an integrated circuit, providing for the formation on a top surface of the integrated circuit of at least a first layer of undoped oxide (5), characterized in that said first layer of undoped oxide (5) is formed by means of a chemical vapor deposition process performed at a pressure suitable for causing said first undoped oxide layer to substantially completely fill hollow regions between projecting regions (2) of the top surface of the integrated circuit.

2. Process according to claim 1, characterized in that said chemical vapor deposition process is a Sub-Atmospheric pressure Chemical Vapor Deposition (SACVD) process.

3. Process according to claim 2, characterized in that said pressure is in the range 350 to 600 Torr.

4. Process according to claim 3, characterized by providing for the formation, prior to said first undoped oxide layer (5), of a second undoped oxide layer (4) following the profile of the top surface of the integrated circuit and acting as a barrier layer.

5. Process according to claim 4, characterized by providing for the formation, over said first undoped oxide layer (5), of a third undoped oxide layer (6) encapsulating the first undoped oxide layer (5).

6. Process according to claim 5, characterized in that said second, first and third undoped oxide layers (4,5,6) are formed in sequence by means of a same chemical vapor deposition process varying the process conditions.

7. Process according to claim 5, characterized by providing for forming, over the third undoped oxide layer (6), of a doped oxide layer (7).

8. Process according to claim 7, characterized by providing for forming, over the layer of doped oxide (7), of a layer of oxidonitride.
